# EUROPEAN PATENT SPECIFICATION

(11) **EP 2 793 455 B1**
(45) Date of publication and mention of the grant of the patent: **23.12.2015**
(21) Application number: 13305513.7
(22) Date of filing: 19.04.2013
(51) Int. Cl.: H04M 11/06, H03F 1/02, H04M 3/18

(54) **Peak Amplitude Equalization For Protection Circuits**
Spitzenamplitudenentzerrung für Schutzschaltungen
Égalisation d'amplitude de crête de circuits de protection

(43) Date of publication of application: 22.10.2014
(73) Proprietor: ALCATEL LUCENT, 92100 Boulogne-Billancourt (FR)
(72) Inventor: Van Den Berg, Eric, 2560 Nijlen (BE); Van BruysselL, Danny, 2820 Bonheiden (BE)
(74) Representative: ALU Antw Patent Attorneys

(56) References cited:
- EP-A1- 1 317 105
- US-A1- 2011 006 822
- BICAKCI A ET AL: "A CMOS line driver for ADSL central office applications", IEEE JOURNAL OF SOLID-STATE CIRCUITS, IEEE SERVICE CENTER, PISCATAWAY, NJ, USA, vol. 38, no. 12, 1 December 2003 (2003-12-01), pages 2201-2208, XP011104265, ISSN: 0018-9200, DOI: 10.1109/JSSC.2003.818570

## Description

### Technical Field of the invention

The present invention relates to transmission arrangements comprising protection circuits against signal surges.

### Technical Background of the invention

The line driver of a Digital subscriber Line (DSL) or many other kinds of telecommunication lines needs to be protected against lightning and power contact surges onto that communications line it drives. See GR-1089 or ITU-T-K20 for some typical requirements.

The protection against such surges occurs in different stages. A first stage (also called primary protection) is made of a carbon block or Gas Discharge Tube (GDT). A second stage is typically implemented by means of a transformer which removes most of the common mode or longitudinal surge energy. Finally the line driver is typically protected by one or more silicon-based Transient voltage suppressor (TVS) diodes.

The problem with TVS diodes, which are capable to absorb most of the energy passing by the primary protection and optional transformer, is that these diodes have a parasitic capacitance that varies depending on the applied voltage, comparable to the operation of a variac diode. This varying parasitic capacitance affects the filter behavior and/or the load impedance at the output of the line driver causing nonlinear or harmonic distortions. The harmonic distortions raise the noise level on the line, thereby reducing the maximum attainable line rate.

Therefore the TVS diode is often isolated from the line driver's output by means of a full bridge rectifier. The parasitic capacitance of the diodes of the full bridge rectifier and their effect on nonlinear distortions are negligible small.

If there were no leakage current, the diodes of the full bridge rectifier would remain in OFF state once the TVS parasitic capacitance is charged by the first maximum amplitude crest at the output of the line driver. Regretfully this is not the case and the parasitic capacitance will slowly discharge. Keeping the diodes of the bridge rectifier in OFF state during normal operation can be achieved by making sure that the parasitic capacitance remains constantly charged at a voltage higher than the maximum output voltage of the line driver.

On a typical class-AB or class-G line driver this can be accomplished by 2 resistors from the line driver's supply rails to the DC output terminals of the full bridge rectifier.

For the lower power consumption class-H line driver, which can generate output voltages beyond the supplied voltage values, two higher voltage supply rails and corresponding power supply units need to be created to keep the TVS parasitic capacitance charged, thereby substantially increasing the Bill of Material (BoM) of the transmission arrangement.

Full bridge rectifier with high surge power clamping device pre-biased with an externally applied DC voltage is today's common solution. With the introduction and generalization of Class-H line drivers, this protection topology requires two additional power supply rails to be generated and distributed over the board, which is sometimes not an economically viable option.

The following background art, which may be regarded as useful for understanding the present invention and its relationship to the prior art, is further acknowledged and briefly discussed.

The US patent application entitled *"Open-Loop Line Driver control Method and Apparatus",* and published on January 13, 2011 with publication number US 2011/0006822 A1, discloses a transmission arrangement including an amplifier and an open-loop control system. The amplifier has an output stage for amplifying a signal, a power supply for driving a supply voltage of the output stage to different voltage levels responsive to being modulated and a pulse width modulator for modulating the power supply responsive to a mask input. The open-loop control system includes a mask generator and a detector. The mask generator is configured to generate the mask input as a function of the envelope of the signal. The detector is configured to detect discontinuities in the mask input and compensate for the discontinuities.

The IEEE paper entitled "A CMOS Line Driver for ADSL central office Application" from Ara Bicakci et al., and published in the Journal of Solid-State Circuits, Vol. 38, No. 12, in December 2003, discloses a transmission arrangement including a line driver utilizing a single 6v supply. The line driver output produces a 20V_{ppd} signal to deliver a 40V_{ppd} swing to a 100Ω line. The adoption of an active termination, a dynamic supply control circuit technique, and deep n-well devices at the output stage of the line driver is key in achieving such a large voltage swing in a 0.25µm CMOS process. In order to ensure reliability of the output devices, the dynamic supply control algorithm is designed to activate only one lift amplifier at each signal path of the differential line driver at any given time. A transformer turns ratio of 1:2.4 ensures both reliability and optimal power dissipation in the presence of system losses. The total power dissipation of the line driver is 700mw when DMT signals with a crest factor of 15dB were used to deliver 20.4dBm to a 100Ω line.

The EP patent application entitled *"Line Driver using a Class G Amplifier and a Programmable Peak Detector*"*,* and published on June 4, 2003 with publication number EP 1 317 105 A1, discloses a transmission arrangement including a peak detector and an amplifier. The peak detector analyzes a digital input signal and triggers a first logic signal if the peak detector detects the digital input signal level crossing a certain threshold. The threshold value can be modified by an overhead. The amplifier employs a plurality of supply rails of differing voltages as a function of the logic signals. A digital signal delay element may delay the signal to allow sufficient time for the amplifier to switch between supply sources. A logic delay element may delay transmittal of the first logic signal by the peak detector to compensate for signal delay caused by a filter. A hold element ensures that the first logic signal is applied to the output amplifier for a given amount of time.

### Summary of the invention

It is an object of the present invention to overcome or alleviate the shortcomings or drawbacks of the prior art solutions.

In accordance with a first aspect of the invention, a transmission arrangement comprises a line driver for driving a transmission line with a transmit signal comprising successive transmit Discrete Multi-Tone (DMT) symbols, and a clamping device for protecting the line driver from signal surges occurring over the transmission line. The transmission arrangement further comprises a peak amplitude equalizer configured to increase the amplitude of selected signal crests of respective transmit DMT symbols up to a desired crest value for recharge of the clamping device. The transmit DMT symbols with the desired crest value are not more than a given number of consecutive DTM symbols apart from each other.

In one embodiment of the invention, the peak amplitude equalizer is configured to determine respective phases and/or amplitudes for one or more reserved tones of the respective transmit DMT symbols that do not carry any control or user data yet that keep on being actively transmitted to yield the desired crest value.

In one embodiment of the invention, the given number is temperature dependent.

In one embodiment of the invention, the transmission arrangement comprises a full bridge rectifier coupled to the clamping device, and the selected signal crests are absolute signal crests of the respective transmit DMT symbols whose amplitude needs to be increased up to an absolute desired crest value.

In one embodiment of the invention, the transmission arrangement comprises a half bridge rectifier coupled to the clamping device, and a further half bridge rectifier coupled to a further clamping device, and the selected signal crests are positive signal crests of first respective transmit DMT symbols whose amplitude needs to be increased up to a positive desired crest value and negative signal crests of second respective transmit DMT symbols whose amplitude needs to be increased up to a negative desired crest value.

In one embodiment of the invention, the positive and negative desired crest values are present in alternate transmit DMT symbols.

Such a transmission arrangement may form part of an access node that supports wired DMT communication over a loop plant, such as a Digital Subscriber Line Access Multiplexer (DSLAM), an Ethernet switch, an edge router, etc. The access node can be deployed at a central office (CO), or as a fiber-fed remote unit closer to subscriber premises (street cabinet, pole cabinet, etc).

Alternatively, such a transmission arrangement may form part of a subscriber device that supports wired DMT communication over a subscriber loop, such as a desktop, a laptop, a Network Interface card (NIC), a modem, a network gateway, a media gateway, etc.

In accordance with another aspect of the invention, a method for driving a transmission line with a transmit signal comprising successive transmit DMT symbols, and comprising protecting a line driver from signal surges occurring over the transmission line by means of a clamping device. The method further comprises increasing the amplitude of selected signal crests of respective transmit DMT symbols up to a desired crest value for recharge of the clamping device. The transmit DMT symbols with the desired crest value are not more than a given number of consecutive DTM symbols apart from each other.

Embodiments of a method according to the invention correspond with the aforementioned embodiments of a transmission arrangement according to the invention.

DMT transmission, also referred to as multi-carrier or OFDM transmission, is a transmission technique whereby In-Phase (I) and Quadrature (Q) components of closely-spaced orthogonal carriers (or tones) are modulated with binary sub-streams of an initial payload stream. Although DMT transmission is very spectral-efficient, the so-produced DMT symbols exhibit high Peak to Average Ratio (PAR), thereby requiring expensive line drivers that are able to operate linearly over a wide range of voltage swings. PAR is defined as the ratio between the maximum absolute amplitude value the signal may take during a given period, e.g. the symbol period, and its Root Mean Square (RMS) value during that same period, or alternatively as the root of the Peak to Average Power ratio (PAPR).

Peak to Average Ratio Reduction (PARR) is a know technique for reducing the amplitude of too high crests in a DMT symbol in order to alleviate the strains on the line driver and to use cheaper amplifiers. For instance, PARR is achieved by adjusting the phases and/or amplitudes of one or more reserved tones that do not carry any payload information, yet that keep on being actively transmitted for PARR purpose. The corresponding carriers are simply discarded by the receiver as they do not carry any meaningful data.

A Peak Amplitude Equalizer (PAE) is now proposed to increase the amplitude of signal crests of sufficiently-close transmit DMT symbols up to a desired crest value in order to gently recharge the leaking capacitance of the clamping device and to remove the extra biasing circuitry and associated power supply unit(s). The desired crest value is such that this value is never exceeded (e.g., by means of PARR, or if the analog transmit signal is clamped to a pre-determined maximum voltage value), or is exceeded on rare occasions (if the induced level of signal distortion is acceptable).

By so doing, the diodes of the bridge rectifier remain OFF for most of the symbol duration, meaning no or little current is diverted towards the clamping device, thereby causing no or little signal distortions.

If a full bridge rectifier is used for isolating the clamping device from the line driver's output, then the crest values of the transmit DMT symbols are equalized in absolute value; if a half bridge rectifier is used instead, then both the positive and negative crest values of the transmit DMT symbols are equalized independently from each other, and not necessarily to the same desired voltage value.

The desired crest values do not need to be present in each and every transmit DMT symbol, but may be a few transmit DMT symbols apart, depending on the amount of leakage current that is slowly discharging the parasitic capacitance of the clamping device, and on the allowed amount of current that can be diverted for recharging this capacitance (i.e., the amount of signal distortions that can be sustained).

For instance, in an advantageous embodiment for the half bridge rectifier, the positive and negative desired crest values are present in alternate transmit DMT symbols, meaning the positive (respectively negative) desired crest values will appear in one transmit DMT symbol out of two.

### Brief Description of the Drawings

The above and other objects and features of the invention will become more apparent and the invention itself will be best understood by referring to the following description of an embodiment taken in conjunction with the accompanying drawings wherein:
- fig. 1 represents a prior art solution for protecting a transceiver;
- fig. 2 represents a new solution for protecting a transceiver as per the present invention;
- fig. 3 represents successively transmitted DMT symbols over time and the effect of peak amplitude equalization as per the present invention; and
- fig. 4 represents an alternative solution for protecting a transceiver as per the present invention.

### Detailed Description of the invention

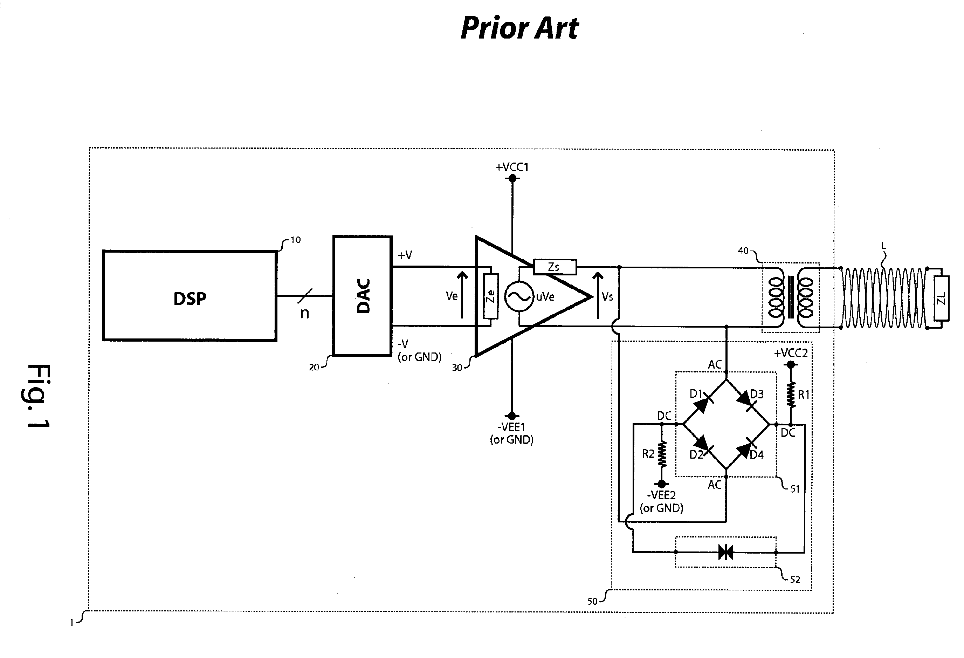

There is seen in fig. 1 a prior art transceiver 1 comprising the following transmit circuitry:
- a Digital signal Processor (DSP) 10 for digitally processing the transmit and receive signals;
- a Digital to Analog Converter (DAC) 20;
- a line driver 30;
- an isolation circuit 40, such as a transformer, coupled to a transmission line L loaded with an impedance ZL; and
- a protection circuit 50.

The receive path within the transceiver 1 has been voluntarily omitted for improved clarity.

The transceiver unit 1 is for instance a DSL transceiver unit, being an ADSL, ADSL2+ or VDSL2 transceiver unit, and the transmission line L is for instance an Unshielded Twisted copper Pair (UTP).

The transceiver unit 1 may be located at a central office (CO) and form part with further analogous transceiver units of an access node, such as a DSLAM, or may be located at customer premises and form part of a Customer Premises Equipment (CPE), such as a modem or a media gateway.

The DSP 10, the DAC 20, the line driver 30 and the isolation circuitry 40 are serially coupled to each other as indicated in fig. 1. The protection circuit 50 is coupled in parallel with the isolation circuit 40.

Between the output of the line driver 30 and the isolation/protection circuits 40/50, there typically is some small impedance (not shown) for e.g. current feedback sensing. This small impedance acts as an additional current limiter in the event of a surge.

The transceiver 1 typically comprises further analog circuitry coupled in series or in parallel as intermediary blocks between the referenced elements, such as a transmit filter for confining the signal energy within the appropriate communication frequency bands, a receive filter for rejecting out-of-band interference, a Low Noise Amplifier (LNA) for amplifying the receive signal with as little noise as possible, a hybrid for coupling the transmitter's output to the transmission line and the transmission line to the receiver's input while achieving low transmitter-receiver coupling ratio (possibly augmented with further echo cancellation techniques), a further receive high-pass filters for filtering out any unwanted signals present in the POTS or ISDN frequency bands, an additional protection circuit such a carbon block or a GDT, etc.

The DSP 10 is arranged to operate a downstream DSL communication channels and an upstream DSL communication channel that are used to convey payload data to/from a given subscriber.

The DSP 10 is further configured to operate a downstream control channel and an upstream control channel that are used to transport control traffic between peer transceivers, such as diagnosis or management commands and responses.

More specifically, the DSP 10 is for encoding and modulating user and control data into digital DMT symbols, and for de-modulating and decoding user and control data from digital DMT symbols.

The following transmit steps are typically performed within the DSP 10:
- data encoding, such as data multiplexing, framing, scrambling, error correction encoding (e.g., Reed Solomon encoding) and interleaving;
- signal modulation, comprising the steps of ordering the carriers according to a carrier ordering table, parsing the encoded bit stream according to the bit loadings of the ordered carriers, and mapping each chunk of bits onto an appropriate transmit constellation point (with respective carrier amplitude and phase), possibly with Trellis coding;
- signal normalization and scaling;
- Inverse Fast Fourier Transform (IFFT);
- Cyclic Prefix (CP) insertion; and possibly
- time-windowing.

The following receive steps are typically performed within the DSP 10:
- CP removal, and possibly time-windowing;
- Fast Fourier Transform (FFT);
- Frequency EQualization (FEQ);
- signal de-modulation and detection, comprising the steps of applying to each and every equalized frequency sample an appropriate constellation grid, the pattern of which depends on the respective carrier bit loading, detecting the expected transmit constellation point and the corresponding transmit bit sequence, possibly with Trellis decoding, and re-ordering all the detected chunks of bits according to the carrier ordering table; and
- data decoding, such as data de-interleaving, error correction decoding (bit or byte errors, if any, are corrected at this stage), de-scrambling, frame delineation and de-multiplexing.

The transmit digital time samples that make up the respective transmit DMT symbols are fed to the DAC 20 via e.g. a data bus comprising n parallel binary digits.

The DAC 20 is for converting the successive digital time samples output by the DSP 10 into a symmetrical analog signal, meaning a signal with equal but opposite voltages to ground on each leg (+V; -V). This symmetrical signal is fed to fully-balanced input terminals of the line driver 30, meaning input terminals having equal impedances to ground and to other circuits.

The line driver 30 is for amplifying a differential transmit signal and supplying the necessary power for driving the transmission line. The line driver is basically plotted in fig. 1 as a differential amplifier amplifying the voltage difference Ve = 2v present on its input terminals to produce an output voltage vs = µve, wherein µ denotes the amplification gain. Let Ze and Zs similarly denote the input and output impedances of the line driver 30.

The line driver 30 is fed with a positive power supply +VCC1 and a negative power supply -VEE1. Typically, the power supply voltages supplied to the line driver 30 are opposite in magnitude (although this is not a strict and necessary condition) and the voltage pair output by the line driver 30 is symmetrical with respect to ground (GND). Yet, VEE1 may differ in magnitude from VCC1, in which case the produced voltage pair would be symmetrical with respect to some virtual ground halfway between +VCC1 and -VEE1.

Still alternatively, the DAC 20 may output an asymmetrical signal (+V; 0) with the ground as reference voltage, and correspondingly the line driver 30 may act as a common mode amplifier, in which case GND substitutes to the negative power supply -VEE1.

The isolation circuit 40 comprises a transformer for isolating the transceiver circuitry from most of the common mode or longitudinal surge energy that may appear on the transmission line L, and for adapting from the low output impedance zs of the line driver 30 to the characteristic impedance of the transmission line L (usually between 100Ω and 120Ω).

The protection circuit 50 is for protecting the line driver against any AC signal surge that may occur over the transmission line on account of e.g. bad contacts or lightnings, and that passes through the transformer 40. The protection circuit 50 limits the output voltage present on the output terminals of the line driver 30 to a predetermined maximum supported voltage value by means of a clamping device 52, presently a TVS diode.

In order to avoid harmonic distortion during normal operation, the protection circuit includes a rectifier 51 to isolate the clamping device 52 from the output of the line driver 30.

Presently, the rectifier 51 is a full-bridge rectifier, which comprises four diodes D1 to D4 mounted as indicated in fig. 1. The AC input terminals of the bridge rectifier 51 are coupled to the output terminals of the line driver 30, and the DC output terminals of the bridge rectifier 51 are coupled to the TVS diode 52.

The DC output terminals of the bridge rectifier 51 are pre-biased by means of two resistors R1 and R2 connected to a positive power supply +VCC2 and a negative power supply -VEE2 respectively (GND substitutes to -VEE2 in case of asymmetrical signals).

In case of a class-AB amplifier, the positive and negative power supply voltage +VCC2 and -VEE2 are equal to +VCC1 and -VEE1, as the signal output by the line driver 30 is not expected to exceed +VCC1 or -VEE1. So the power supply rails of the amplifier need to be extended up to the biasing circuitry.

In case of a class-H amplifier, the positive power supply voltage +VCC2 is greater than +VCC1 and the negative power supply voltage -VEE2 is lower than -VEE1 as they shall respectively match the maximum positive and negative voltage values potentially output by the line driver 30, meaning two extra power supply rails and two extra power supply units are needed for the biasing circuitry exclusively.

The diodes D1 to D4 are constantly in OFF state (high impedance) during normal operation, i.e. when the output voltage of the line driver 30 is within the allowed limit. If a signal surge occurs over the transmission line that exceeds any of the supply voltages +VCC2 or -VEE2, the diodes starts conducting and the TVS diode 52 clamps the output voltage to a pre-determined value while diverting a substantial part of the extra current that may damage the line driver circuitry on account of the low output impedance zs.

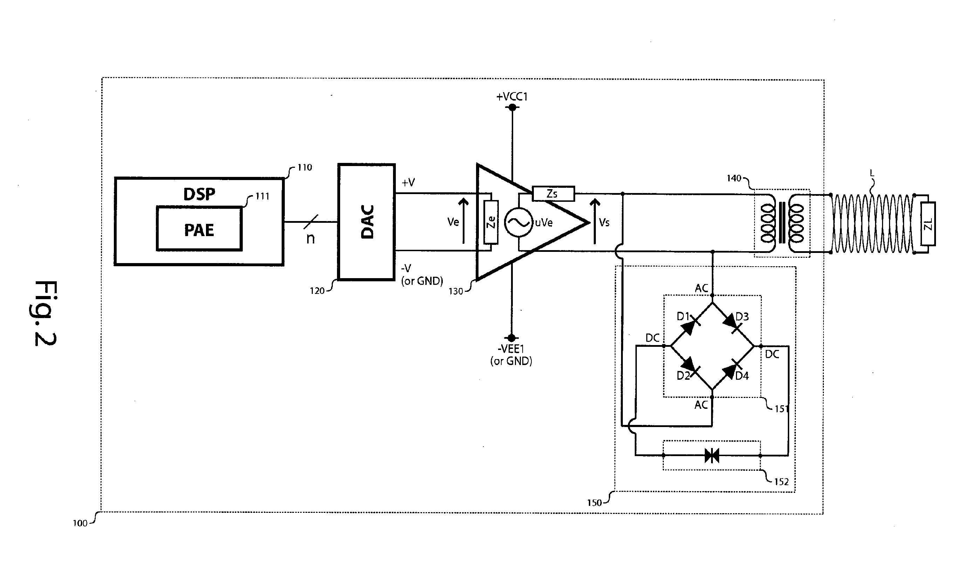

There is seen in fig. 2 a transceiver 100 as per the present invention comprising the following transmit circuitry:
- a Digital Signal Processor (DSP) 110 for digitally processing the transmit and receive signals;
- a Digital to Analog Converter (DAC) 120;
- a line driver 130;
- an isolation circuit 140, such as a transformer, coupled to a transmission line loaded with an impedance ZL; and
- a protection circuit 150, which comprises a rectifying circuit 151 and a clamping device 152.

The transceiver 100 and its components are as per the previously described transceiver 1 and corresponding components with alike numerals, except for the following noticeable differences.

The clamping device 152 is no-longer pre-biased: the resistors R1 and R2 and the corresponding power supply units and power supply rails can be removed, thereby substantially reducing the BoM of the transceiver 100 compared to the transceiver 1.

Instead, the DSP 110 further includes a Peak Amplitude Equalizer (PAE) 111, which aims at maintaining absolute crest values of successively transmitted DMT symbols to a desired absolute value denoted as |VOPT| in order to gently recharge the clamping device 152. This small recharging current does not cause any substantial harmonic distortions for the transmit signal as only a very small fraction of the driving current is diverted towards the clamping device 152.

The desired value |VOPT| is preferably chosen within the linear output voltage range of the line driver 130, and close to the maximum absolute voltage value that the line driver 130 can linearly sustain.

For equalizing the amplitude crests the PAE 111 makes use of reserved tones that do not carry any payload data yet that keep on being transmitted. The PAE 111 first determines the absolute peak amplitude for a given transmit DMT symbol that would be reached without modulating the reserved tones, as well as the time sample at which the absolute peak value is reached. The PAE 111 next determines appropriate phases and amplitudes for the reserved tones so as, when combined with the other active carriers, the so-determined maximum absolute value is reduced or increased to the desired absolute value |VOPT| by constructive or destructive interference. The desired absolute peak value |VOPT| can be reached at the time sample where the absolute peak amplitude was initially observed, or a few time samples apart depending on the exact interference pattern.

The PAE 111 does not need to equalize each and every transmit DMT symbol. Depending on the actual amount of leakage current and on the charge available to recharge the parasitic capacitance without distorting the useful signal too much, the PAE 111 may decide to leave a few intermediary DMT symbols with an absolute peak value lower than the desired absolute peak value |VOPT| unchanged, while still reducing too-high crests whenever applicable. The maximum time between two consecutive charges may be temperature-dependent.

Also, peak amplitude reduction may be optional. For instance, the linear output range may be such that only very few transmit DMT symbols exceeds the maximum output voltage that the line driver 130 can linearly sustain, yielding very few signal distortions that can be easily recovered by means of error recovery techniques, such as Forward Error Correction (FEC) or Automatic Repetition reQuest (ARQ). Also, the DSP 110 may implement some extra processing steps in order to reduce the likelihood of too high signal crests, such as an extra Discrete Fourier Transform (DFT) step as in SC-FDMA.

Also, it is possible that, besides the intended peak amplitude reduction or increase, a new too-high crest is created at another location. In this case, the PAE 111 needs to iteratively determine new phase and/or amplitude values for the reserved tones till the transmit DMT symbol is suitably equalized. Such an iterative process already exists for PARR. However, the risk for creating another unwanted crest for a crest decrease is higher and more difficult to control than this is the case for a crest increase as per the present invention.

As a further improvement, the equalization algorithm may be executed on each and every transmit DMT symbol, yet in case an unwanted crest is created then the iterative process is aborted and adjourned for another subsequent transmit DMT symbol (provided of course there are not too may consecutive transmit DMT symbols since the last equalized one), thereby saving some processing power.

Other techniques can be used for equalizing the absolute peak amplitudes of the successively transmitted DMT symbols in substitution to, or in combination with, the 'reserved tones' technique, such as insertion of an additional noisy signal that is actively superimposed on the regular data signal, appropriate data encoding and scrambling to achieve the required peak amplitude, voluntary corruption of well chosen carriers relying on the error control to remedy the induced data corruption, appropriate signal constellation scaling, etc. Some of these techniques require the sending of encoding or modulating information to the remote receiver for proper decoding or demodulation. Some other techniques, such as the reserved tones, do not.

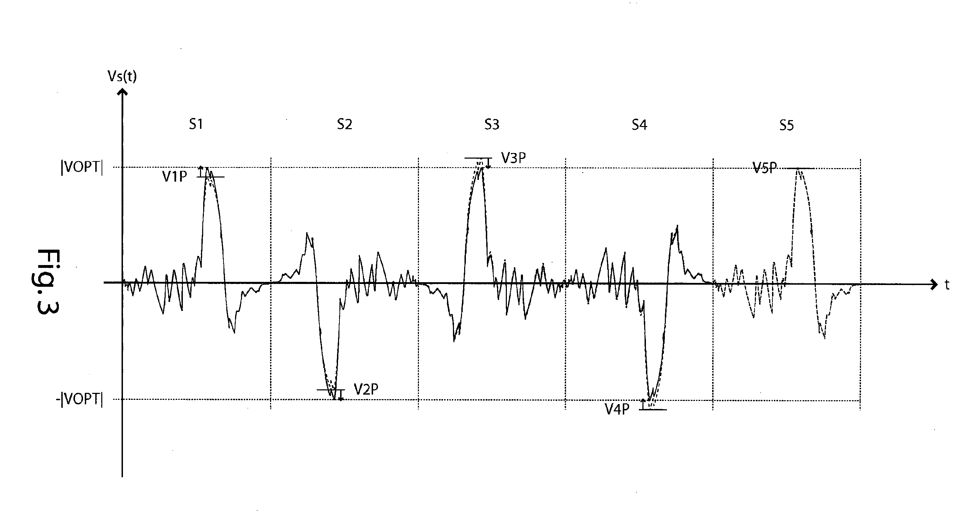

The operation of the PAE 111 will now be elucidated with reference to fig. 3, wherein the differential voltage vs(t) output by the line driver 130 is plotted versus time for successive transmit DMT symbols 51 to S5. The transmit DMT symbols are shown before (dotted lines) and after (solid lines) peak amplitude equalization by the PAE 111.

In this exemplary operation, all successive transmit DMT symbols have their respective crest values equalized in absolute value.

For instance, the output differential voltage during the transmit DMT symbol S1 is expected to reach a peak or crest value V1P that is positive with |V1P| = V1P < |VOPT|. If so, the PAE 111 adjusts the phase and amplitude of the reserved tones to increase the positive peak value of the transmit DMT symbol s1 from V1P up to |VOPT|.

Further in time, the output differential voltage during the transmit DMT symbol S2 is expected to reach a peak value V2P that is negative with |v2P| = -V2P < |VOPT|. If so, the PAE 111 adjusts the phase and amplitude of the reserved tones to decrease the negative peak value of the transmit DMT symbol S2 from v2P down to -|VOPT|, or alternatively to increase the absolute peak value from |V2P| up to |VOPT|.

Still further in time, the output differential voltage during the transmit DMT symbol S3 is expected to reach a peak value V3P that is positive with |V3P| = V3P > |VOPT|. If so, the PAE 111 adjusts the phase and amplitude of the reserved tones to decrease the positive peak value of the transmit DMT symbol S3 from V3P down to |VOPT|.

Still further in time, the output differential voltage during the transmit DMT symbol S4 is expected to reach a peak value V4P that is negative with |V4P| = -V4P > |VOPT|. If so, the PAE 111 adjusts the phase and amplitude of the reserved tones to increase the negative peak value of the transmit DMT symbol S4 from V4P up to -|VOPT|, or alternatively to decrease the absolute peak value from |V4P| down to |VOPT|.

Still further in time, a fifth transmit DMT symbol S5 is transmitted whose absolute peak value |V5P| substantially match |VOPT|, i.e. |VOPT| - δ ≤ |V5P| ≤ |VOPT| + δ wherein δ denotes a small voltage margin. Then the PAE leaves the transmit DMT symbol S5 unchanged as its absolute peak value is already deemed to be suitable (no solid line for that DMT symbol).

Alternatively, the PAE 111 can equalize the absolute peak amplitudes of the successively transmitted DMT symbols irrespective of how close is the original peak value from the desired one.

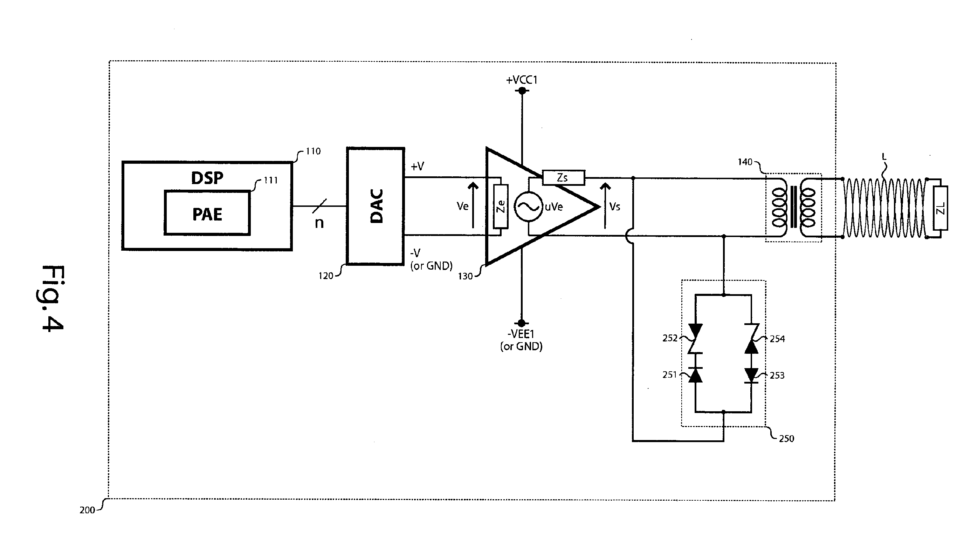

There is seen in fig. 4 an alternative transceiver 200 as per the present invention, wherein an alternative protection circuit 250 comprising two anti-parallel half bridge rectifiers 251 and 253 serially coupled with two respective Zener diodes 252 and 254 substitutes for the protection circuit 150.

This alternative protection circuit 250 can benefit just as well from the PAE algorithm to keep the parasitic capacitance of the Zener diodes 252 and 254 charged. Yet, the protection circuit 250 now needs peak amplitude equalization for both the positive and negative alternations, meaning that the positive crest values are equalized to a first desired positive crest value while the negative crest values are equalized to a second desired negative crest value, which is not necessarily equal in absolute value to the first positive desired crest value (the positive alternations may be equalized at another desired voltage value than the negative alternations). The desired positive and negative crest values for gently recharging the respective Zener diodes 252 and 254 can be present within the same transmit DMT symbols (this might require complex equalization methods and/or the use of a larger number of reserved tones), or in different transmit DMT symbols. For instance, the positive and negative desired crest values may appear in alternate DMT symbols.

The protection circuit 250 actually has an advantage over the protection circuit 150 with a full bridge rectifier and a TVS diode. During a surge, we typically see ringing, thus a series of alternating peaks. The positive peaks will be absorbed by one Zener diode, while the negative peaks will be absorbed by the other Zener diode, giving some time for each Zener diode to recover from the peak power.

The clamping device is not necessarily a TVS diode or a Zener diode, and may refer to any passive or active device that exhibit varying capacitance and that is configured to clamp the voltage to a pre-determined maximum value and to absorb a large current without damage.

For instance, a crow bar can be used as clamping device. A crow bar is a device that shorts its two terminals in case an excessive voltage (due to an external surge) is detected (e.g., a thyristor). In order to turn off the crow bar, the forward voltage/current needs to fall down below the threshold current, but due to the nature of the differential DSL signal this will anyway happen almost instantaneously after the surge is over. These crow bar devices have similar vary-cap characteristics and will also benefit from peak amplitude equalization as per the present invention.

It is to be noticed that the term *"comprising"* should not be interpreted as being restricted to the means listed thereafter. Thus, the scope of the expression "a *device comprising means A and B*" should not be limited to devices consisting only of components A and B. It means that with respect to the present invention, the relevant components of the device are A and B.

It is to be further noticed that the term "*coupled*" should not be interpreted as being restricted to direct connections only. Thus, the scope of the expression *"a device A coupled to a device B*" should not be limited to devices or systems wherein an output of device A is directly connected to an input of device B, and/or vice-versa. It means that there exists a path between an output of A and an input of B, and/or vice-versa, which may be a path including other devices or means.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, a processor should not be construed to refer exclusively to hardware capable of executing software, and may implicitly include, without limitation, digital signal processor (DSP) hardware, network processor, application specific integrated circuit (ASIC), field programmable gate array (FPGA), etc. Other hardware, conventional and/or custom, such as read only memory (ROM), random access memory (RAM), and non volatile storage, may also be included.

## Claims

1. **A transmission arrangement** (100; 200) comprising **a line driver** (130) for driving **a transmission line** (L) with **a transmit signal** (vs) consisting **of successive transmit Discrete Multi-Tone DMT symbols** (S1 to S5), and **a clamping device** (152; 252; 254) for protecting the line driver from **signal surges** occurring over the transmission line,
*wherein* the transmission arrangement further comprises **a peak amplitude equalizer** (111) configured to increase the amplitude of **selected signal crests** (V1P; V2P) of **respective transmit DMT symbols** (S1; S2) up to **a desired crest value** (VOPT) for recharge of the clamping device
*and wherein* the transmit DMT symbols with the desired crest value are not more than a **given number** of consecutive DTM symbols apart from each other.

2. **A transmission arrangement** (100; 200) according to claim 1, *wherein* the peak amplitude equalizer is configured to determine respective phases and/or amplitudes for **one or more reserved tones** of the respective transmit DMT symbols that do not carry any control or user data yet that keep on being actively transmitted to yield the desired crest value.

3. **A transmission arrangement** (100; 200) according to claim 1, *wherein* the given number is temperature dependent.

4. **A transmission arrangement** (100) according to claim 1 or 2, *wherein* the transmission arrangement comprises **a full bridge rectifier** (151) coupled to the clamping device (152), *and wherein* the selected signal crests are absolute signal crests of the respective transmit DMT symbols whose amplitude needs to be increased up to **an absolute desired crest value** (| VOPT|).

5. **A transmission arrangement** (200) according to claim 1 or 2, *wherein* the transmission arrangement comprises **a half bridge rectifier** (251) coupled to the clamping device (252), and **a further half bridge rectifier** (253) coupled to **a further clamping device** (254),
*and wherein* the selected signal crests are positive signal crests of **first respective transmit DMT symbols** whose amplitude needs to be increased up to **a positive desired crest value** and negative signal crests of **second respective transmit DMT symbols** whose amplitude needs to be increased up to a **negative desired crest value.**

6. **A transmission arrangement** (200) according to claim *5, wherein* the positive and negative desired crest values are present in alternate transmit DMT symbols.

7. **An access node** supporting wired DMT communication, and comprising **a transmission arrangement** (100; 200) according to any of claims 1 to 6.

8. **An access node** according to claim 7, wherein the access node is **a Digital Subscriber Line Access Multiplexer DSLM.**

9. **A subscriber device** supporting wired DMT communication, and comprising **a transmission arrangement** (100; 200) according to any of claims 1 to 6.

10. **A method** for driving **a transmission line** (L) with **a transmit signal** (vs) consisting of **successive Discrete Multi-Tone DMT symbols** (S1 to S5), and comprising protecting **a line driver** (130) from **signal surges** occurring over the transmission line by means of **a clamping device** (152; 252; 254),
*wherein* the method further comprises increasing the amplitude of **selected signal crests** (V1P; V2P) of **respective transmit DMT symbols** (S1; s2) up to **a desired crest value** (VOPT) for recharge of the clamping device,
*and wherein* the transmit DMT symbols with the desired crest value are not more than a **given number** of consecutive DTM symbols apart from each other.

## Patentansprüche

1. **Übertragungsanordnung** (100; 200), umfassend einen **Leitungstreiber** (130) zum Verstärken einer **Übertragungsleitung** (L) mit einem **Sendesignal** (Vs), bestehend aus **aufeinanderfolgenden Sende-Mehrtonverfahrens-DMT-Symbolen** (S1 bis S5), und eine **Klemmvorrichtung** (152; 252; 254) für den Schutz des Leitungstreibers vor **Signalstößen,** die über die Übertragungsleitung auftreten,
*wobei* die Übertragungsanordnung weiterhin einen **Spitzenamplitudenentzerrer** (111) umfasst, der ausgelegt ist, um die Amplitude von **ausgewählten Signalspitzen** (V1 P; V2P) von **jeweiligen Sende-DMT-Symbolen** (S1; S2) auf einen **gewünschten Spitzenwert** (VOPT) zum Aufladen der Klemmvorrichtung zu erhöhen,
*und wobei* die Sende-DMT-Symbole mit dem gewünschten Spitzenwert nicht mehr sind als **eine gegebene Anzahl** von aufeinanderfolgenden DTM-Symbolen, die voneinander getrennt sind.

2. **Übertragungsanordnung** (100; 200) nach Anspruch 1, *wobei* der Spitzenamplitudenentzerrer ausgelegt ist, um jeweilige Phasen und/oder Amplituden für **einen oder mehrere reservierte Töne** der jeweiligen Sende-DMT-Symbole zu bestimmen, die noch keine Steuerungs- oder Benutzerdaten tragen, die weiter aktiv übertragen werden, um den gewünschten Spitzenwert zu ergeben.

3. **Übertragungsanordnung** (100; 200) nach Anspruch 1, *wobei* die gegebene Anzahl temperaturabhängig ist.

4. **Übertragungsanordnung** (100) nach Anspruch 1 oder 2, *wobei* die Übertragungsanordnung einen **Vollbrückengleichrichter** (151) umfasst, der an die Klemmvorrichtung (152) gekoppelt ist,
*und wobei* die ausgewählten Signalspitzen absolute Signalspitzen der jeweiligen Sende-DMT-Symbole sind, deren Amplitude auf einen **absoluten gewünschten Spitzenwert** (|VOPT|) erhöht werden muss.

5. **Übertragungsanordnung** (200) nach Anspruch 1 oder 2, *wobei* die Übertragungsanordnung einen **Halbbrückengleichrichter** (251) umfasst, der an die Klemmvorrichtung (252) gekoppelt ist, und einen **weiteren Halbbrückengleichrichter** (253), der an eine **weitere Klemmvorrichtung** (254) gekoppelt ist,
*und wobei* die ausgewählten Signalspitzen positive Signalspitzen von **ersten jeweiligen Sende-DMT-Symbolen** sind, deren Amplitude auf einen **positiven gewünschten Spitzenwert** erhöht werden muss, und negative Signalspitzen von **zweiten jeweiligen Sende-DMT-Symbolen,** deren Amplitude auf **einen negativen gewünschten Spitzenwert** erhöht werden muss.

6. **Übertragungsanordnung** (200) nach Anspruch 5, *wobei* die positiven und negativen gewünschten Spitzenwerte in alternierenden Sende-DMT-Symbolen vorhanden sind.

7. **Zugangsknoten,** der eine drahtgebundene DMT-Kommunikation unterstützt, und umfassend eine **Übertragungsanordnung** (100; 200) nach einem beliebigen der Ansprüche 1 bis 6.

8. **Zugangsknoten** nach Anspruch 7, wobei der Zugangsknoten ein **Digital Subscriber Line Access Multiplexer DSLAM** ist.

9. **Teilnehmergerät,** das eine drahtgebundene DMT-Kommunikation unterstützt, und umfassend eine **Übertragungsanordnung** (100; 200) nach einem beliebigen der Ansprüche 1 bis 6.

10. **Verfahren** zum Verstärken einer **Übertragungsleitung** (L) mit einem **Sendesignal** (Vs), bestehend aus **aufeinanderfolgenden Mehrtonverfahrens-DMT-Symbolen** (s1 bis s5), und umfassend das Schützen eines **Leitungstreibers** (130) vor **Signalstößen,** die über die Übertragungsleitung auftreten, mittels einer **Klemmvorrichtung** (152; 252; 254),
*wobei* das Verfahren weiterhin das Erhöhen der Amplitude von **ausgewählten Signalspitzen** (V1 P; V2P) von **jeweiligen Sende-DMT-Symbolen** (s1; s2) auf einen **gewünschten Spitzenwert** (VOPT) zum Aufladen der Klemmvorrichtung umfasst,
*und wobei* die Sende-DMT-Symbole mit dem gewünschten Spitzenwert nicht mehr sind als eine **gegebene Anzahl** von aufeinanderfolgenden DTM-Symbolen, die voneinander getrennt sind.

## Revendications

1. **Dispositif d'émission** (100 ; 200) comprenant **un circuit de commande de ligne** (130) pour commander **une ligne de transmission** (L) avec **un signal d'émission** (Vs) comprenant **des symboles de multitonalité discrète DMT d'émission successifs** (s1 à s5), et **un dispositif d'écrêtage** (152 ; 252 ; 254) pour protéger le circuit de commande de ligne de **pointes de signal** survenant sur la ligne de transmission,
*dans lequel* le dispositif d'émission comprend en outre **un égaliseur d'amplitude de crête** (111) configuré pour augmenter l'amplitude de **crêtes de signal sélectionnées** (V1P ; V2P) de **symboles DMT d'émission respectifs** (s1 ; s2) jusqu'à **une valeur de crête souhaitée** (VOPT) pour recharger le dispositif d'écrêtage
*et dans lequel* les symboles DMT d'émission ayant la valeur de crête souhaitée ne sont pas supérieurs à un **nombre donné** de symboles DTM consécutifs espacés les uns des autres.

2. **Dispositif d'émission** (100; 200) selon la revendication 1, *dans lequel* l'égaliseur d'amplitude de crête est configuré pour déterminer des phases et/ou des amplitudes respectives pour **une ou plusieurs tonalités réservées** des symboles DMT d'émission respectifs qui ne transportent aucune donnée de commande ou d'utilisateur mais qui continuent à être activement transmis pour obtenir la valeur de crête souhaitée.

3. **Dispositif d'émission** (100; 200) selon la revendication 1, *dans lequel* le nombre donné dépend de la température.

4. **Dispositif d'émission** (100) selon la revendication 1 ou 2, *dans lequel* le dispositif d'émission comprend **un redresseur en pont complet** (151) couplé au dispositif d'écrêtage (152), *et dans lequel* les crêtes de signal sélectionnées sont des crêtes de signal absolues des symboles DMT d'émission respectifs dont l'amplitude doit être augmentée jusqu'à **une valeur de crête absolue souhaitée** (|VOPT|).

5. **Dispositif d'émission** (200) selon la revendication 1 ou 2, *dans lequel* le dispositif d'émission comprend **un redresseur en demi-pont** (251) couplé au dispositif d'écrêtage (252), et **un autre redresseur en demi-pont** (253) couplé à **un autre dispositif d'écrêtage** (254),
*et dans lequel* les crêtes de signal sélectionnées sont des crêtes de signal positives de **premiers symboles DMT d'émission respectifs** dont l'amplitude doit être augmentée jusqu'à **une valeur de crête positive souhaitée** et des crêtes de signal négatives de **deuxièmes symboles DMT d'émission respectifs** dont l'amplitude doit être augmentée jusqu'à **une valeur de crête négative souhaitée.**

6. **Dispositif d'émission** (200) selon la revendication 5, *dans lequel* les valeurs de crête positive et négative souhaitées sont présentes dans des symboles DMT d'émission alternatifs.

7. **Noeud d'accès** prenant en charge une communication DMT filaire, et comprenant **un dispositif d'émission** (100 ; 200) selon l'une quelconque des revendications 1 à 6.

8. **Noeud d'accès** selon la revendication 7, dans lequel le noeud d'accès est un **multiplexeur d'accès de ligne d'abonné numérique DSLAM**.

9. **Dispositif d'abonné** prenant en charge une communication DMT filaire, et comprenant **un dispositif d'émission** (100 ; 200) selon l'une quelconque des revendications 1 à 6.

10. **Procédé** pour commander **une ligne de transmission (L)** avec **un signal d'émission** (Vs) comprenant des **symboles de multitonalité discrète DMT successifs** (S1 à S5), et consistant à protéger **un circuit de commande de ligne** (130) de **pointes de signal** survenant sur la ligne de transmission au moyen **d'un dispositif d'écrêtage** (152 ; 252 ; 254),
*dans lequel* le procédé comprend en outre l'augmentation de l'amplitude de **crêtes de signal sélectionnées** (V1P ; V2P) de **symboles DMT d'émission respectifs** (s1 ; s2) jusqu'à **une valeur de crête souhaitée** (VOPT) pour recharger le dispositif d'écrêtage,
*et dans lequel* les symboles DMT d'émission ayant la valeur de crête souhaitée ne sont pas supérieurs à un **nombre donné** de symboles DTM consécutifs espacés les uns des autres.
